# EUROPÄISCHE PATENTANMELDUNG

(11) **EP 1 087 650 A2**
(43) Veröffentlichungstag der Anmeldung: **28.03.2001**
(21) Anmeldenummer: 00119681.5
(22) Anmeldetag: 08.09.2000
(51) Int. Cl.: H05K 5/03

(54) **Gehäusedeckel mit Aufstellvorrichtung**

(30) Priorität: 21.09.1999 DE 29916610 U
(71) Anmelder: FSL Finishing Services Vertriebsgesellschaft für Deutschland GmbH, 64807 Dieburg (DE)
(72) Erfinder: Gutierrez, Antonio, 64385 Heichelsheim (DE)
(74) Vertreter: Katscher, Helmut, Dipl.-Ing.

(57) **Zusammenfassung**

Ein Gehäusedeckel (3) für ein Gehäuse (1) eines Bearbeitungsgeräts für elektrische Leiterplatten o.dgl. weist eine Deckelstütze auf. Der Gehäusedeckel (3) ist in einen Deckelrahmen (4) lose eingelegt, der an zwei entgegengesetzten Seiten des Gehäuses (1) seitliche Deckelwiderlager (4a) aufweist. Am Gehäusedeckel (3) ist beiderseits im Abstand zum Deckelschwerpunkt (8) jeweils eine Pendelstütze (6) gelagert, deren Stützenfuß (9) längs des Deckelrahmens (4) bewegbar ist. In der angehobenen Stellung des Gehäusedeckels (3) greift der Stützenfuß (9) an einem Stützenwiderlager (11) am Deckelrahmen (4) an. Jede der beiden Pendelstützen (6) ist jeweils in einer nahe am Deckelschwerpunkt (8) angeordneten Stützenlagerung (7a) gelagert.

## Beschreibung

Die Erfindung betrifft einen Gehäusedeckel mit Aufstellvorrichtung für ein Gehäuse eines Bearbeitungsgeräts für elektrische Leiterplatten o.dgl., mit mindestens einer den Gehäusedeckel in einer schräg angehobenen Stellung stützenden Deckelstütze.

Bearbeitungsgeräte für elektrische Leiterplatten sind üblicherweise zu mehreren miteinander verkettet und in einer Reihe aufgestellt. Die Bearbeitungsgeräte sind daher nur von den beiden gegenüberliegenden Seiten zugänglich, wobei beispielsweise auf der einen Geräteseite Steuerungseinrichtungen und auf der gegenüberliegenden Geräteseite Einrichtungen für die Zufuhr von flüssigen Chemikalien angeordnet sind. Zum Einrichten und Überwachen der Bearbeitungsgeräte sind deren an der Gehäuseoberseite liegende Gehäusedeckel aufklappbar oder abnehmbar.

Die aufklappbare Ausführung der Gehäusedeckel hat den Vorteil, daß der Gehäusedeckel auch in seiner schräg angehobenen Stellung über dem Gehäuse verbleibt, so daß an der Deckelinnenseite herablaufende chemische Flüssigkeit in das Gehäuse zurückläuft und nicht zu einer Verunreinigung der Umgebung führt. Nachteilig ist jedoch, daß der Gehäusedeckel jeweils nur von einer Seite her aufgeklappt werden kann und die obere Gehäuseöffnung deshalb nur entweder von der Seite der Steuerung oder von der Seite der Zufuhr flüssiger Chemikalien her zugänglich ist. Dadurch werden die Einrichtungs- und Wartungsarbeiten erschwert.

Daneben ist es auch bekannt, den Gehäusedeckel abnehmbar auszuführen. Der Gehäusedeckel ist in einen Deckelrahmen nur lose eingelegt und kann vollständig abgenommen werden. Dadurch wird zwar eine Zugänglichkeit von beiden Gehäuseseiten her ermöglicht; beim Abnehmen des Gehäusedeckels tropft oder läuft aber die chemische Flüssigkeit von der Deckelunterseite ab; dies führt zu Verunreinigungen und bei unvorsichtiger Handhabung sogar zu Schäden, da es sich zumeist um aggressive Flüssigkeiten handelt.

Aufgabe der Erfindung ist es daher, einen Gehäusedeckel mit Aufstellvorrichtung der eingangs genannten Gattung so auszubilden, daß der Gehäusedeckel wahlweise von beiden Gehäuseseiten her geöffnet werden kann und dabei aber in seiner schräg angehobenen Stellung über dem Gehäuse verbleibt, so daß die an der Deckelunterseite anhaftende Flüssigkeit nur in das Gehäuse zurücktropft oder zurückläuft.

Diese Aufgabe wird erfindungsgemäß dadurch gelöst, daß der Gehäusedeckel in einen Deckelrahmen lose eingelegt ist, der an zwei entgegengesetzten Seiten des Gehäuses seitliche Deckelwiderlager aufweist, und daß am Deckel beiderseits zum Deckelschwerpunkt jeweils eine Pendelstütze gelagert ist, deren Stützenfuß längs des Deckelrahmens bewegbar ist und in der angeghobenen Stellung des Gehäusedeckels an einem Stützenwiderlager am Deckelrahmen angreift.

Der nur lose in den Deckelrahmen eingelegte Gehäusedeckel kann wahlweise von jeder der beiden Gehäuseseiten her angehoben werden, wobei er mit seiner unten liegenden Deckelkante am zugeordneten Deckelwiderlager abgestützt wird. Diejenige der beiden unabhängig voneinander bewegbaren Pendelstützen, die der angehobenen Deckelseite zugeordnet ist, stützt den Gehäusedeckel an dieser angehobenen Seite ab.

Da jede der beiden Pendelstützen im Abstand zum Deckelschwerpunkt angreift, ist sichergestellt, daß der Gehäusedeckel in seiner angehobenen Stellung eine stabile Lage einnimmt, weil sich sein Deckelschwerpunkt zwischen dem unteren, seitlichen Deckelwiderlager und der Lagerung derjenigen Pendelstütze befindet, die den Gehäusedeckel in dieser Stellung stützt. Die jeweils andere Pendelstütze wird dabei nur lose angehoben und bewirkt keine Abstützung des Gehäusedeckels.

In entsprechender Weise kann der Gehäusedeckel von der jeweils anderen Gehäuseseite her angehoben werden. Dadurch ist die obere Gehäuseöffnung wahlweise von der einen oder der anderen Gehäuseseite her zugänglich. Da der jeweils untere Deckelrand am Deckelwiderlager im Deckelrahmen verbleibt, gelangt die an der Innenseite des schräg angehobenen Gehäusedeckels herablaufende Flüssigkeit wieder in das Gehäuse und führt nicht zu einer Verunreinigung der Umgebung.

Gemäß einer bevorzugten Ausführungsform der Erfindung ist vorgesehen, daß jede Pendelstütze von den beiden Schenkeln eines im wesentlichen U-förmigen Stützenbügels gebildet werden, dessen die Schenkel verbindender Bügelsteg am Gehäusedeckel schwenkbar gelagert ist.

Damit ergibt sich bei sehr geringem Bauaufwand eine stabile Abstützung des Gehäusedeckels durch jede der beiden Pendelstützen an zwei gegenüberliegenden Punkten des Deckelrahmens. Jede der beiden wahlweise einsetzbaren Pendelstützen bildet hierbei eine zweibeinige Stütze.

Obwohl der Gehäusedeckel nur lose in den Deckelrahmen eingelegt ist, wird er auch ohne die Verwendung eines Scharniers o.dgl. in seiner schräg angehobenen Stellung stabil gehalten, weil er nicht nur mit seiner unten liegenden Deckelkante am seitlichen Deckelwiderlager, sondern auch nahe seinen beiden schräg verlaufenden Deckelrändern über die beiden Schenkel des Stützenbügels abgestützt ist.

Die Verwendung des U-förmigen Stützenbügels ermöglicht darüber hinaus eine besonders einfache und stabile Schwenklagerung der Pendelstütze am Deckel. Vorzugsweise ist jeder Bügelsteg in zwei im Abstand zueinander angeordneten Lagerböcken gelagert, wobei jeweils zwei benachbarte Lagerböcke der beiden Bügelstege zu einem gemeinsamen Doppellagerbock zusammengefaßt sein können. Der Gehäusedeckel kann dabei aus einer flachen Deckelplatte bestehen, wobei die Lagerböcke bzw. die Doppellagerböcke an der Deckelunterseite angebracht sind. Dies erleichtert die Herstellung des Gehäusedeckels aus einer Glasscheibe oder Acrylglasscheibe.

Weitere vorteilhafte Ausgestaltungen des Erfindungsgedankens sind Gegenstand weiterer Unteransprüche.

Nachfolgend wird ein Ausführungsbeispiel der Erfindung näher erläutert, das in der Zeichnung dargestellt ist. Es zeigt:
Fig. 1 einen vereinfachten senkrechten Schnitt im oberen Bereich eines Gehäuses eines Bearbeitungsgeräts für elektrische Leiterplatten o.dgl. und
Fig. 2 einen vereinfachten Schnitt längs der Linie II-II in Fig. 1.

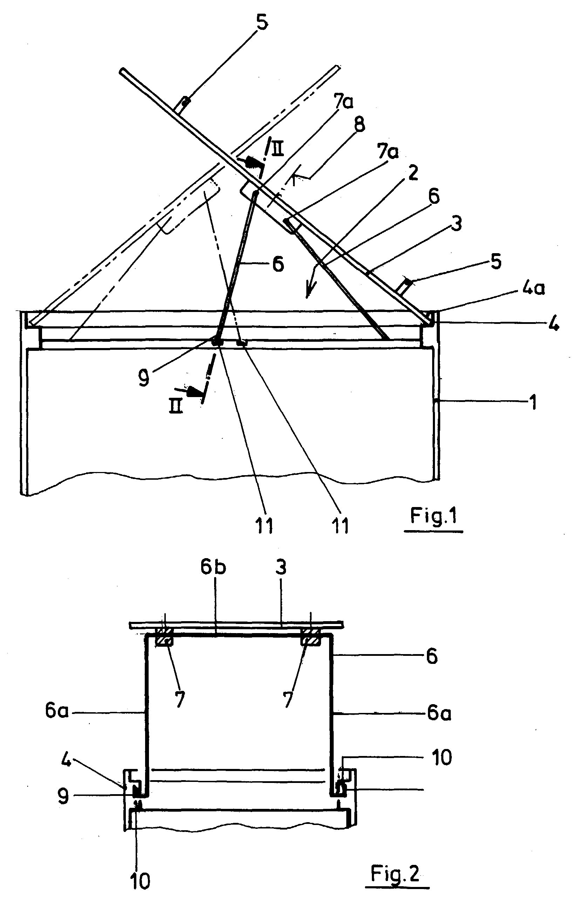

Das in Fig. 1 nur in seinem oberen Bereich in einem vereinfachten Schnitt dargestellte Gehäuse 1 eines Bearbeitungsgeräts für elektrische Leiterplatten o.dgl. weist eine obere Gehäuseöffnung 2 auf, die durch einen Gehäusedeckel 3 verschließbar ist. Der beim dargestellten Ausführungsbeispiel aus einer flachen Acrylglasplatte bestehende Gehäusedeckel 3 liegt im geschlossenen Zustand in einem Deckelrahmen 4, der einen umlaufenden Rand 4a aufweist.

Da derartige Bearbeitungsgeräte üblicherweise mit anderen, entsprechenden Geräten verkettet und in einer Reihe aufgestellt sind, soll die Gehäuseöffnung 2 von beiden Seiten her zugänglich sein, d.h. in der Darstellung in Fig. 1 von rechts und von links. Der Gehäusedeckel 3 weist nahe seinen beiden seitlichen Rändern an seiner Oberseite jeweils einen Griff 5 zum Anheben des Gehäusedeckels 3 auf.

An der Deckelunterseite sind zwei jeweils eine Pendelstütze bildende U-förmige Stützenbügel 6 gelagert. Jeder der beiden Stützenbügel 6 weist zwei Schenkel 6a und einen die Schenkel 6a verbindenden Bügelsteg 6b auf, der am Gehäusedeckel 3 in zwei im Abstand zueinander angeordneten Lagerböcken 7 gelagert ist, die an der Deckelunterseite angebracht, beispielsweise angeschraubt sind.

Wie man aus Fig. 1 erkennt, liegen die beiden Lager 7a der beiden Stützenbügel 6 beiderseits im Abstand zum Deckelschwerpunkt 8. Jeweils zwei benachbarte Lagerböcke 7 der beiden Bügelstege 6b sind jeweils zu einem gemeinsamen Doppellagerbock zusammengefaßt.

Die freien Enden 9 der Schenkel 6a der Stützenbügel 6 sind in entgegengesetzten Richtungen abgewinkelt (Fig. 2) und ragen in Führungsschlitze 10 des Deckelrahmens 4. Nahe der Mitte zwischen den beiden Gehäuseseiten sind am Führungsschlitz 10 Stützenwiderlager 11 ausgespart, in die jeweils ein durch ein abgewinkeltes Ende 9 gebildeter Stützenfuß in der angehobenen Stellung des Gehäusedeckels eingreift.

Jede der beiden Pendelstützen 6 ist somit in einer nahe am Deckelschwerpunkt 8 angeordneten Stützenlagerung 7a gelagert. Die Stützenwiderlager 11 für beide Pendelstützen 6 sind im mittleren Bereich des Deckelrahmens 4 zwischen den beiden seitlichen Deckelwiderlagern angeordnet.

In Fig. 1 ist der Gehäusedeckel 3 mit ausgezogenen Linien in seiner einen schräg angehobenen Stellung gezeigt. Die durch den linken Stützenbügel 6 gebildete Pendelstütze greift mit ihren beiden Schenkeln und deren Enden 9 in das linke Stützenwiderlager 11 ein. Mit seiner unten liegenden Kante stützt sich der Gehäusedeckel 3 dabei am umlaufenden Rand 4a ab, der ein seitliches Deckelwiderlager bildet. In dieser Stellung ist die Gehäuseöffnung 2 von links her zugänglich.

In entsprechender Weise kann der Gehäusedeckel in die in Fig. 1 mit strichpunktierten Linien dargestellte andere, schräg angehobene Stellung gebracht werden, damit die Gehäuseöffnung 2 von rechts her zugänglich ist. Dabei wird nur der rechte Stützenbügel 6 wirksam, der dann in das rechte Stützenwiderlager 11 eingreift. Die dann unten liegende linke Deckelkante stützt sich am linken seitlichen Deckelwiderlager ab.

## Patentansprüche

1. Gehäusedeckel (3) mit Aufstellvorrichtung für ein Gehäuse (1) eines Bearbeitungsgeräts für elektrische Leiterplatten o.dgl., mit mindestens einer den Gehäusedeckel (3) in einer schräg angehobenen Stellung stützenden Deckelstütze, dadurch gekennzeichnet, daß der Gehäusedeckel (3) in einen Deckelrahmen (4) lose eingelegt ist, der an zwei entgegengesetzten Seiten des Gehäuses (1) seitliche Deckelwiderlager (4a) aufweist, und daß am Deckel (3) beiderseits im Abstand zum Deckelschwerpunkt (8) jeweils eine Pendelstütze (6) gelagert ist, deren Stützenfuß (9) längs des Deckelrahmens (4) bewegbar ist und in der angehobenen Stellung des Gehäusedeckels (3) an einem Stützenwiderlager (11) am Deckelrahmen (4) angreift.

2. Gehäusedeckel nach Anspruch 1, dadurch gekennzeichnet, daß jede der beiden Pendelstützen (6) jeweils in einer nahe am Deckelschwerpunkt (8) angeordneten Stützenlagerung (7a) gelagert ist.

3. Gehäusedeckel nach Anspruch 1 oder 2, dadurch gekennzeichnet, daß die Stützenwiderlager (11) für beide Pendelstützen (6) im mittleren Bereich des Deckelrahmens (4) zwischen den beiden seitlichen Deckelwiderlagern angeordnet sind.

4. Gehäusedeckel nach Anspruch 1, dadurch gekennzeichnet, daß jede Pendelstütze von den beiden Schenkeln (6a) eines im wesentlichen U-förmigen Stützenbügels (6) gebildet werden, dessen die Schenkel (6a) verbindender Bügelsteg (6b) am Gehäusedeckel (3) schwenkbar gelagert ist.

5. Gehäusedeckel nach Anspruch 4, dadurch gekennzeichnet, daß jeder Bügelsteg (6b) in zwei im Abstand zueinander angeordneten Lagerböcken (7) gelagert ist.

6. Gehäusedeckel nach Anspruch 5, dadurch gekennzeichnet, daß jeweils zwei benachbarte Lagerböcke der beiden Bügelstege (6b) zu einem gemeinsamen Doppellagerbock zusammengefaßt sind.

7. Gehäusedeckel nach Anspruch 5 oder 6, dadurch gekennzeichnet, daß der Gehäusedeckel (3) aus einer flachen Deckelplatte besteht und die Lagerböcke bzw. die Doppellagerböcke an der Deckelunterseite angebracht sind.

8. Gehäusedeckel nach Anspruch 4, dadurch gekennzeichnet, daß die in entgegengesetzten Richtungen abgewinkelten freien Enden (9) der Schenkel (6a) der Stützenbügel (6) in Führungsschlitze (10) des Deckelrahmens (4) ragen.
